# EUROPEAN PATENT APPLICATION

(11) **EP 2 843 836 A1**
(43) Date of publication of application: **04.03.2015**
(21) Application number: 13182012.8
(22) Date of filing: 28.08.2013
(51) Int. Cl.: H03K 17/082, H03K 17/18, G01R 31/327, H02H 3/08, H03K 17/13

(54) **Solid state power controller and method for monitoring a solid state power controller**

(71) Applicant: Airbus Operations GmbH, 21129 Hamburg (DE)
(72) Inventor: Johannsen, Martin, 22889 Tangstedt (DE)
(74) Representative: Isarpatent

(57) **Abstract**

The present invention pertains to a solid state power controller, SSPC, device (1), comprising: a switching system (2) including at least one solid state power switching device (3a; 3b; 3n); a current sensor unit (5) coupled in series to the switching system (2); and a control device (6) having a sensor input terminal (6a) coupled to the current sensor unit (5), and a switch control output terminal (6b) coupled to the switching system (2). The control device (6) is configured to operate the switching system (2) in an active operational mode by keeping the at least one solid state power switching device (3a; 3b; 3n) closed. The control device (6) is further configured to control the switching system (2) to open the at least one solid state power switching device (3a; 3b; 3n) intermittently for a monitoring interval the duration of which is shorter than a predetermined threshold. The control device (6) is further configured to detect a current through the switching system (2) by reading out an output value of the current sensor unit (5) during the monitoring intervals.

## Description

The present invention relates to a solid state power controller and a method for monitoring a solid state power controller, in particular for aircraft power distribution architectures.

Modern aircraft power distribution architectures usually employ solid state power controller (SSPC) devices. The underlying principle for an SSPC is based upon one or more semiconductor switching devices coupled in series with a sensing device for detecting the switch current. Depending on the detected switch current by the sensing device, a control unit is configured to implement guarding functions for the switching devices in case of a failure in any of the components of the SSPC device.

Particularly in avionics it is desirable to provide a high level of system stability and reliability against failures in the power distribution. Therefore, a conventional measure is the provision of fusible links in the current path of the SSPC device to lower the system failure rates when the SSPC is subject to a failure.

One approach for disposing with the need for using a fusible link is to provide an additional under-rated electromechanical controller in the current path and in series to the switching devices of an SSPC device, such as for example disclosed in document US 2011/0222200 A1.

Other solutions involve providing parallel redundant current paths with redundant SSPC devices for a single load that are able to switch within the transparency time of the load, as for example taught in document US 8,344,545 B2.

However, there is still a need for solutions which maintaining reliability and safeguarding against failures of an SSPC device without the need for fusible links.

One object of the invention is therefore to reduce the complexity and weight of an SSPC device as well as the voltage drop over a SSPC device and at the same time maintain a high reliability and low failure rates of the SSPC device.

This object is achieved by an SSPC device having the features of claim 1, by an aircraft having the features of claim 7, and by a method for monitoring a solid state power controller having the features of claim 8.

A first aspect of the invention is directed to a solid state power controller (SSPC) device, comprising a switching system including at least one solid state power switching device; a current sensor unit coupled in series to the switching system; and a control device having a sensor input terminal coupled to the current sensor unit, and a switch control output terminal coupled to the switching system. The control device is configured to operate the switching system in an active operational mode by keeping the at least one solid state power switching device closed. The control device is further configured to control the switching system to open the at least one solid state power switching device intermittently for a monitoring interval the duration of which is shorter than a predetermined threshold. The control device is further configured to detect a current through the switching system by reading out an output value of the current sensor unit during the monitoring intervals.

A second aspect of the invention is directed to an aircraft, comprising an SSPC device according to the first aspect of the invention.

A third aspect of the invention is directed to a method for monitoring a solid state power controller, SSPC, device, the SSPC device comprising a switching system including at least one solid state power switching device, a current sensor unit coupled in series to the switching system, and a control device having a sensor input terminal coupled to the current sensor unit and having a switch control output terminal coupled to the switching system. The method comprises the steps of operating the switching system in an active operational mode by keeping the at least one solid state power switching device closed; during the operational mode, opening the at least one solid state power switching device intermittently for a monitoring interval the duration of which is shorter than a predetermined threshold; and detecting a current through the switching system by reading out an output value of the current sensor unit during the monitoring intervals.

The idea on which the present invention is based is to increase the frequency of monitoring intervals for an SSPC device so that the need for a fusible link to increase reliability and safety can be obviated. This is achieved by introducing very short monitoring intervals that may be performed within the transparency guard band of a load protected by the SSPC device. The monitoring intervals may then be performed during normal operation of the SSPC device without disrupting performance and functionality of the SSPC device.

Advantageously, there is no longer a need for a fusible link to be connected in series to the SSPC device for safety reasons. This will reduce space requirements, system tolerances and voltage drop which is especially beneficial for downstream system weight. Weight saving is particularly advantageous for applications in aviation and avionics.

Moreover, the abbreviation of the duration of the monitoring intervals leads to improved flexibility in the frequency and timing of the monitoring intervals. The monitoring intervals may also be employed for both AC and DC power distribution architectures.

According to an embodiment of the SSPC device, the current sensor unit may comprise a shunt resistor or a hall probe.

According to a further embodiment of the SSPC device and of the method, the predetermined threshold may be below the transparency time of a load coupled to and fed with power by the solid state power switching device.

According to a further embodiment of the SSPC device and of the method, the predetermined threshold may be 3 ms or less, preferably between 2 ms and 2.5 ms.

According to a further embodiment of the SSPC device, the SSPC device may be fed by an alternating current and the monitoring interval may begin at a zero crossing of the alternating current and end when the voltage at the switching system is zero.

The invention will be explained in greater detail with reference to exemplary embodiments depicted in the drawings as appended.

The accompanying drawings are included to provide a further understanding of the present invention and are incorporated in and constitute a part of this specification. The drawings illustrate the embodiments of the present invention and together with the description serve to explain the principles of the invention. Other embodiments of the present invention and many of the intended advantages of the present invention will be readily appreciated as they become better understood by reference to the following detailed description. The elements of the drawings are not necessarily to scale relative to each other. Like reference numerals designate corresponding similar parts.
Fig. 1 schematically illustrates an aircraft including an SSPC device according to an embodiment of the invention.
Fig. 2 schematically illustrates a power distribution architecture for an aircraft according to a further embodiment of the invention.
Fig. 3 schematically illustrates an SSPC device according to a further embodiment of the invention.
Fig. 4 schematically illustrates a method for monitoring an SSPC device according to a further embodiment of the invention.

In the figures, like reference numerals denote like or functionally like components, unless indicated otherwise. Any directional terminology like "top", "bottom", "left", "right", "above", "below", "horizontal", "vertical", "back", "front", "clockwise", "counter-clockwise" and similar terms are merely used for explanatory purposes and are not intended to delimit the embodiments to the specific arrangements as shown in the drawings.

Although specific embodiments have been illustrated and described herein, it will be appreciated by those of ordinary skill in the art that a variety of alternate and/or equivalent implementations may be substituted for the specific embodiments shown and described without departing from the scope of the present invention. Generally, this application is intended to cover any adaptations or variations of the specific embodiments discussed herein.

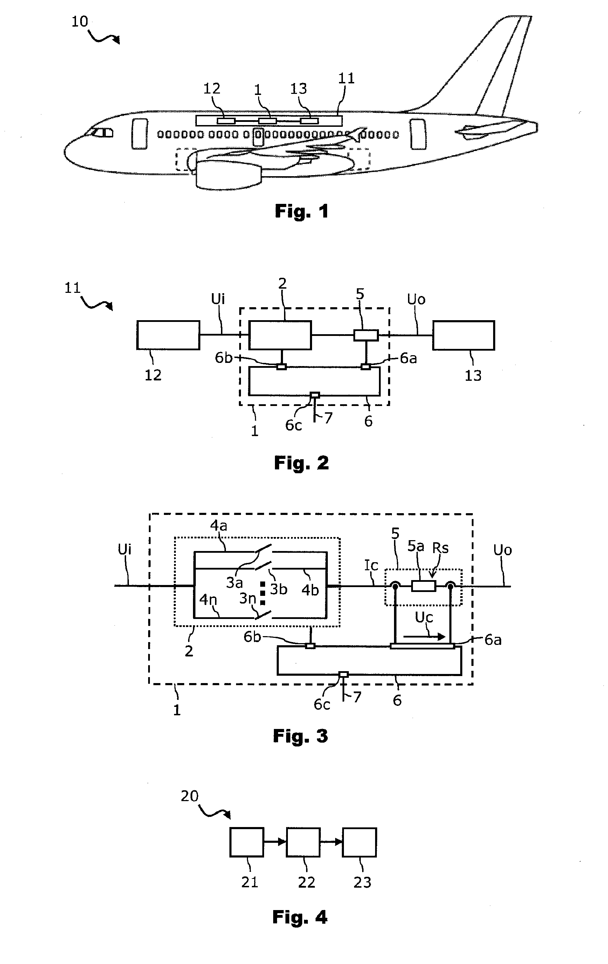

Fig. 1 shows a schematic illustration of an aircraft 10 having an SSPC device 1. The aircraft 10 by way of example comprises a power distribution architecture 11 having a power source 12, for example a generator, a fuel cell or a high voltage battery, and an electrical load 13, which may be any aircraft system or subsystem that draws electrical power in use.

The power source 12 and the load 13 are coupled by means of a solid state power controller (SSPC) device 1 which may be a hardware component including one or more controllable circuit breaking components which have to be enabled for the SSPC device to provide power from the power source 12 to a particular electrical load 13. The SSPC device 1 may be under control of a controlling unit that monitors the operational state of the elements of the SSPC device 1. In particular, when any failure, defect or irregularity is detected that might lead to potential overloads or other harm to the associated electrical components of the power distribution architecture 11 the controlling unit is able to take measures to shut down the power source 12 and/or the SSPC device 1 for safety reasons. Usually, the required failure rates and failure response times are bounded by upper limits set by official regulations of aviation associations. Therefore, the SSPC device 1 is designed with corresponding inbuilt failsafe mechanisms to meet the officially prescribed limits.

Fig. 2 schematically shows a power distribution architecture 11 for an aircraft, for example the aircraft 10 in Fig. 1. The power distribution architecture 11 may for example be employed in primary power distribution networks of the aircraft. The power distribution architecture 11 may be used for AC power distribution networks as well as for DC power distribution networks.

A power source 12, for example a generator, a fuel cell or a high voltage battery or accumulator, may supply an input voltage Ui to an SSPC device 1. The SSPC device 1 may include semiconductor devices configured to control the voltage and/or current supplied to a load 13. The SSPC device 1 may include a switching system 2 that is configured to selectively connect or disconnect the power source 12 from the load 13. In series to the switching system 2 a current sensor unit 5 is coupled which is adapted to detect the current being momentarily supplied to the load 13.

A control device 6 is coupled to both the switching system 2 via a switch control output terminal 6b and the current sensor unit 5 via a sensor input terminal 6a. The control device 6 is configured to perform supervisory and diagnostic functions in order to identify overload conditions and prevent short circuits. The SSPC device 1 may designed to switch alternating current (AC) voltages. It may also be possible for the SSPC device 1 to switch direct current (DC) voltages. As a further alternative, the SSPC device 1 may be an AC/DC controller which is configured to switch both AC and DC voltages. To that end, the control device 6 may comprise any type of controlling element that is capable to performing logical operations. For example, the control device 6 may be a microprocessor, a microcontroller, an ASIC, an FPGA or a CPLD. The control device 6 may in particular comprise one or more of an arithmetic logic unit (ALU), a memory component, a timer component, a counter component and input/output (I/O) ports. The control device 6 may specifically comprise a state signal output terminal 6c for outputting state signals 7 indicating the operational state of the SSPC device 1 as well as various fault, failure or defect conditions to an external system, such as an aircraft control system.

Fig. 3 schematically shows an SSPC device 1 which may for example be employed in a power distribution architecture 11 for an aircraft, such as the aircraft 10 in Fig. 1. The SSPC device 1 may in particular be employed in the power distribution architecture 11 as shown in Fig. 2.

The switching system 2 of the SSPC device 1 comprises one or more switching branches or switching paths 4a, 4b, ..., 4n which are coupled in parallel to each other. In the exemplary embodiment of Fig. 3 there are three switching paths 4a, 4b, 4n shown, however, as will be apparent to the skilled person in the art, any other number of switching paths 4a, 4b, ..., 4n may be employed as well. Each of the switching paths 4a, 4b, ..., 4n comprises a respective solid state power switching device 3a, 3b, ..., 3n, for example a semiconductor switching device such as a MOSFET, an IGBT, a JFET, a BJT or any other suitable power semiconductor switching element. The solid state power switching devices 3a, 3b, ..., 3n may for example be implemented on the same chip substrate.

The control device 6 is configured to control the switching operation of the solid state power switching devices 3a, 3b, 3n via switching signals outputted at the switch control output terminal 6b to the switching system 2. For example, it may be preferable for the control device 6 to generate a common switching signal which is configured to control the solid state power switching devices 3a, 3b, ..., 3n to switch in unison.

In order to generate the switching signals the control device 6 is adapted to receive detection values of a current Ic momentarily flowing through the switching system 2. The detection of the current may for example be performed using a shunt resistor 5a in the current sensor unit 5 over which a shunt voltage Uc may be measured. The SSPC current Ic may then be calculated from the measured shunt voltage Uc depending on the known resistivity Rs of the shunt resistor 5a. It may also be possible to use alternative solutions or measures to detect the SSPC current Ic in the current sensor unit 5, for example Hall effect IC sensors or Rogowski coils.

The control device 6 is configured to operate the switching system 2 in an active operational mode by keeping the solid state power switching devices 3a, 3b, ..., 3n closed so that the load 13 is provided with an output voltage Uo and a concomitant current from the power source 12. The control device 6 needs to test the active components of the SSPC device 6 periodically in order to ensure the reliability requirements. The control device 6 may for this purpose be configured to control the switching system 2 to open the solid state power switching devices 3a, 3b, ..., 3n intermittently for a monitoring interval. The monitoring interval has a duration which is shorter than a predetermined threshold.

The monitoring interval can advantageously be performed during the active operational mode, that is during the load 13 is supplied with electrical power from the power source 12. The load 13 has a transparency time during which the current and/or voltage supply can be cut off temporarily without adverse effects to the function of the load 13. If the duration of the monitoring interval is less than the transparency time of the load 13, the control device 6 is able to test the SSPC device 1 for failures or defects without having to temporarily terminate the active operational mode of the load 13.

To that end, the predetermined threshold may be below the transparency time of the load 13 coupled to and fed with power by the switching system 2. For example, in case of an AC power source 12, the transparency time is usually 10 ms. The transparency time in case of a DC power source 12 is usually 3 ms. Therefore, the predetermined threshold may be advantageously set to 3 ms or less, preferably between 2 ms and 2.5 ms. During the monitoring intervals the solid state power switching devices 3a, 3b, ..., 3n may be opened, and the control device 6 is configured to detect a current through the switching system 2 by reading out an output value of the current sensor unit 5 during the monitoring intervals. After the monitoring intervals have elapsed, the control device 6 is configured to close the solid state power switching devices 3a, 3b, ..., 3n again in order to continue the active operational mode of the load 13.

When the SSPC device 1 is fed by an alternating current, the monitoring intervals may begin at a zero crossing of the alternating current and may end when the voltage at the switching system 2 is zero. That way, the switching losses at the solid state power switching devices 3a, 3b, ..., 3n may be reduced.

Fig. 4 shows a schematical illustration of a method 20 for monitoring a solid state power controller (SSPC) device. The method 20 may for example be used to monitor the SSPC device 1 of Fig. 3, for example when employed in a power distribution architecture 11 as illustrated in Fig. 2 and/or in an aircraft 10 as illustrated in Fig. 1.

At a first step 21, the switching system 2 of the SSPC device 1 is operated in an active operational mode by keeping the at least one solid state power switching device 3a, 3b, ..., 3n closed. An operational mode may comprise the feeding of electrical power from the power source 12 to the electrical load 13 for purposes of operating the load 13 in its intended function.

During the operational mode, the second step 22 of opening the at least one solid state power switching device 3a, 3b, ..., 3n may be performed intermittently. The opening of the solid state power switching devices 3a, 3b, ..., 3n may be performed for a monitoring interval the duration of which is shorter than a predetermined threshold. The predetermined threshold may preferably be below the transparency time of the load 13 coupled to and fed with power by the solid state power switching device. Typical transparency times of loads 13 in AC power distribution networks are in the order of 10 ms, while typical transparency times of loads 13 in DC power distribution networks are in the order of about 3 ms. Thus, the predetermined threshold may be chosen as 3 ms or less, particularly between 2 ms and 2.5 ms.

In a third step 23, a current through the switching system 2 may be detected by reading out an output value of the current sensor unit 5 during the monitoring intervals. The read-out current may then be compared to expected values in order to detect abnormal or potentially hazardous operation conditions. For example, for all cases where there is no current or a current below a certain minimum threshold is detected when the solid state power switching devices 3a, 3b, ..., 3n are closed or where there is current above a certain maximum threshold is detected when the solid state power switching devices 3a, 3b, ..., 3n are opened, the assumption must be made that an overcurrent cannot be reliably detected in time and, hence, not prevented. For this case, the control device 6 may issue a warning signal to shut down the SSPC device 1 for safety reason or to disable the active operational mode of the SSPC device 1.

In the foregoing detailed description, various features are grouped together in one or more examples or examples with the purpose of streamlining the disclosure. It is to be understood that the above description is intended to be illustrative, and not restrictive. It is intended to cover all alternatives, modifications and equivalents. Many other examples will be apparent to one skilled in the art upon reviewing the above specification.

The embodiments were chosen and described in order to best explain the principles of the invention and its practical applications, to thereby enable others skilled in the art to best utilize the invention and various embodiments with various modifications as are suited to the particular use contemplated. In the appended claims and throughout the specification, the terms "including" and "in which" are used as the plain-English equivalents of the respective terms "comprising" and "wherein," respectively. Furthermore, "a" or "one" does not exclude a plurality in the present case.

### List of reference numerals and signs

- 1: SSPC device
- 2: Switching system
- 3a: Switching device
- 3b: Switching device
- 3n: Switching device
- 4a: Switching path
- 4b: Switching path
- 4n: Switching path
- 5: Current sensor unit
- 5a: Shunt resistor
- 6: Control device
- 6a: Sensor input terminal
- 6b: Switch control output terminal
- 6c: State signal output terminal
- 7: State signal
- 10: Aircraft
- 11: Power distribution architecture
- 12: Power source
- 13: Load
- 20: Method
- 21: Method step
- 22: Method step
- 23: Method step
- Ic: SSPC current
- Rs: Sensor unit resistance
- Uc: Current sensor voltage
- Ui: Input voltage
- Uo: Output voltage

## Claims

1. Solid state power controller, SSPC, device (1), comprising:
a switching system (2) including at least one solid state power switching device (3a; 3b; 3n);
a current sensor unit (5) coupled in series to the switching system (2); and
a control device (6) having a sensor input terminal (6a) coupled to the current sensor unit (5), and a switch control output terminal (6b) coupled to the switching system (2),
wherein the control device (6) is configured to operate the switching system (2) in an active operational mode by keeping the at least one solid state power switching device (3a; 3b; 3n) closed,
wherein the control device (6) is further configured to control the switching system (2) to open the at least one solid state power switching device (3a; 3b; 3n) intermittently for a monitoring interval the duration of which is shorter than a predetermined threshold, and
wherein the control device (6) is further configured to detect a current through the switching system (2) by reading out an output value of the current sensor unit (5) during the monitoring intervals.

2. SSPC device (1) according to claim 1, wherein the current sensor unit (5) comprises a shunt resistor (5a) or a hall probe.

3. SSPC device (1) according to one of the claims 1 and 2,
wherein the predetermined threshold is below the transparency time of a load (13) coupled to and fed with power by the solid state power switching device (3a; 3b; 3n).

4. SSPC device (1) according to claim 3, wherein the predetermined threshold is 3 ms or less.

5. SSPC device (1) according to claim 4, wherein the predetermined threshold is between 2 ms and 2.5 ms.

6. SSPC device (1) according to one of the claims 1 to 5,
wherein the SSPC device (1) is fed by an alternating current and wherein the monitoring interval begins at a zero crossing of the alternating current and ends when the voltage at the switching system (2) is zero.

7. Aircraft, comprising an SSPC device (1) according to one of the claims 1 to 6.

8. Method (20) for monitoring a solid state power controller, SSPC, device (1), the SSPC device (1) comprising a switching system (2) including at least one solid state power switching device (3a; 3b; 3n), a current sensor unit (5) coupled in series to the switching system (2), and a control device (6) having a sensor input terminal (6a) coupled to the current sensor unit (5) and having a switch control output terminal (6b) coupled to the switching system (2), the method (20) comprising:
operating (21) the switching system (2) in an active operational mode by keeping the at least one solid state power switching device (3a; 3b; 3n) closed;
during the operational mode, opening (22) the at least one solid state power switching device (3a; 3b; 3n) intermittently for a monitoring interval the duration of which is shorter than a predetermined threshold; and detecting (23) a current through the switching system (2) by reading out an output value of the current sensor unit (5) during the monitoring intervals.

9. Method (20) according to claim 8, wherein the predetermined threshold is below the transparency time of a load (13) coupled to and fed with power by the solid state power switching device (3a; 3b; 3n).

10. Method (20) according to claim 9, wherein the predetermined threshold is 3 ms or less.

11. Method (20) according to claim 10, wherein the predetermined threshold is between 2 ms and 2.5 ms.
